# EUROPEAN PATENT APPLICATION

(11) **EP 3 419 067 A1**
(43) Date of publication of application: **26.12.2018**
(21) Application number: 17753319.7
(22) Date of filing: 17.02.2017
(51) Int. Cl.: H01L 51/44

(54) **SOLID-JUNCTION PHOTOELECTRIC CONVERSION ELEMENT MODULE AND METHOD FOR MANUFACTURING SAME**

(30) Priority: 18.02.2016 JP 2016028712
(71) Applicant: Sekisui Chemical Co., Ltd., Osaka-shi, Osaka 530-8565 (JP)
(72) Inventor: FUJINUMA, Naohiro, Tsukuba-shi Ibaraki 300-4292 (JP); ANZAI, Junichiro, Tsukuba-shi Ibaraki 300-4292 (JP)
(74) Representative: Müller-Boré & Partner Patentanwälte PartG mbB
(86) International application number: PCT/JP2017/005909
(87) International publication number: WO 2017/142064

(57) **Abstract**

The present invention provides a solid-junction photoelectric conversion element module (10) including a first photoelectric conversion element (C1), a second photoelectric conversion element (C2), a connection portion (J), and a base material (1). The first photoelectric conversion element and the second photoelectric conversion element are disposed adjacently to each other on a surface of the base material. The first photoelectric conversion element (C1) sequentially includes a first conductive layer (2a), a power generation layer (3a) including a perovskite layer, and a second conductive layer (4a), and the first conductive layer (2a) of the first photoelectric conversion element is in contact with the base material (1). The second photoelectric conversion element (C2) sequentially includes a first conductive layer (2b), a power generation layer (3b) including a perovskite layer, and a second conductive layer (4b), and the first conductive layer (2b) of the second photoelectric conversion element is in contact with the base material (1). The connection portion (J) connects the second conductive layer (4a) of the first photoelectric conversion element and the first conductive layer (2b) of the second photoelectric conversion element, and is in contact with the power generation layer (3a) of the first photoelectric conversion element and the power generation layer (3b) of the second photoelectric conversion element.

## Description

### Technical Field

The present invention relates to a solid-junction photoelectric conversion element module and a method for manufacturing the same.

Priority is claimed on Japanese Patent Application No. 2016-028712, filed on February 18, 2016, the content of which is incorporated herein by reference.

### Background Art

Recently, it is reported that a solid-junction photoelectric conversion element, which includes a power generation layer that contains a perovskite compound, exhibits high photoelectric conversion efficiency (Non-Patent Document 1), and the solid-junction photoelectric conversion element has attracted attention as a new photoelectric conversion element. Starting from the report, an improvement of additional photoelectric conversion efficiency has been successively reported (for example, Non-Patent Document 2).

A single cell voltage of the solid-junction photoelectric conversion element is approximately 1.0 V, and it is necessary to connect a plurality of cells in series so as to obtain a practical voltage.

As a series connection structure of a solar cell in the related art, for example, a W-type structure (Patent Document 1), a Z-type structure (Patent Document 2), a monolithic structure (Fig. 1 in Patent Document 3), and the like have been reported.

### Citation List

### Non-Patent Literature

[Non-Patent Document 1] "Efficient Hybrid Solar Cells Based on Meso-Superstructured Organometal Halide Perovskites" Science, 2012, 338, pages 643 to 647.
[Non-Patent Document 2] "Solvent engineering for high-performance inorganic-organic hybrid perovskite solar cells" Nature Materials 2014, 13, pages 897 to 903.

### Patent Literature

[Patent Document 1] Japanese Unexamined Patent Application, First Publication No. H8-306399
[Patent Document 2] Japanese Unexamined Patent Application, First Publication No. 2007-12377
[Patent Document 3] Japanese Unexamined Patent Application, First Publication No. 2004-303463

### Summary of Invention

### Technical Problem

However, it is necessary to form a power generation layer including an N-type semiconductor layer, a perovskite layer, and a P-type semiconductor layer in a predetermined pattern during manufacturing of the structure of any one of the above-described series connection structure, and thus an advanced manufacturing technology is required. Specifically, in a case of patterning and forming the power generation layer, which is divided into a plurality of partitions, on a single substrate, there is a concern that a deviation may occur in the thickness of the perovskite layer due to an influence of a mask. In addition, in a case of forming a non-pattern (solid-coating) power generation layer and forming a pattern through etching, it is necessary to individually etch a plurality of layers which constitute the power generation layer, and thus manufacturing process becomes complicated. As a result, there is a problem that a manufacturing yield of a solar cell deteriorates.

The invention has been made in consideration of the above-described circumstances, and an object thereof to provide a solid-junction photoelectric conversion element module including a series connection structure of which a manufacturing process can be simplified, and a method for manufacturing the solid-junction photoelectric conversion element module.

### Solution to Problem

[1] According to an aspect of the invention, there is provided a solid-junction photoelectric conversion element module including: a first photoelectric conversion element; a second photoelectric conversion element; a connection portion; and a base material. The first photoelectric conversion element and the second photoelectric conversion element are disposed adjacently to each other on a surface of the base material. The first photoelectric conversion element sequentially includes a first conductive layer, a power generation layer including a perovskite layer, and a second conductive layer, and the first conductive layer of the first photoelectric conversion element is in contact with the base material. The second photoelectric conversion element sequentially includes a first conductive layer, a power generation layer including a perovskite layer, and a second conductive layer, and the first conductive layer of the second photoelectric conversion element is in contact with the base material. The connection portion connects the second conductive layer of the first photoelectric conversion element and the first conductive layer of the second photoelectric conversion element, and is in contact with the power generation layer of the first photoelectric conversion element and the power generation layer of the second photoelectric conversion element.
[2] In the solid-junction photoelectric conversion element module according to [1], the connection portion may be continuously disposed along a space between the first photoelectric conversion element and the second photoelectric conversion element.
[3] In the solid-junction photoelectric conversion element module according to [1], the connection portion may be discontinuously disposed along a space between the first photoelectric conversion element and the second photoelectric conversion element.
[4] In the solid-junction photoelectric conversion element module according to any one of [1] to [3], the connection portion may be formed from a conduction material.
[5] In the solid-junction photoelectric conversion element module according to any one of [1] to [3], the connection portion may include an extension portion in which an end of the second conductive layer of the first photoelectric conversion element extends and which is connected to the first conductive layer of the second photoelectric conversion element, and a compression material that is disposed along the extension portion.
[6] In the solid-junction photoelectric conversion element module according to [4], the conduction material may protrude from a rear surface of the base material.
[7] In the solid-junction photoelectric conversion element module according to any one of [1] to [6] may further include an insulating material that covers the second conductive layer of the first photoelectric conversion element, the connection portion, and the second conductive layer of the second photoelectric conversion element.
[8] According to another aspect of the invention, there is provided a method for manufacturing the solid-junction photoelectric conversion element module according to [4]. The method includes: a step of forming the first conductive layer of the first photoelectric conversion element, and the first conductive layer of the second photoelectric conversion element which is spaced away from the first conductive layer of the first photoelectric conversion element on the base material; a step of forming a continuous power generation layer including a perovskite layer over the first conductive layer of the first photoelectric conversion element and the first conductive layer of the second photoelectric conversion element; a step of forming the second conductive layer of the first photoelectric conversion element and the second conductive layer of the second photoelectric conversion element, which is spaced away from the second conductive layer of the first photoelectric conversion element, on the power generation layer; a step of forming the connection portion by inserting the conduction material between the second conductive layer of the first photoelectric conversion element and the second conductive layer of the second photoelectric conversion element from the second conductive layer side of the first photoelectric conversion element, and pressing the conduction material until the conduction material penetrates through the power generation layer and comes into contact with the first conductive layer of the second photoelectric conversion element.
[9] According to still another aspect of the invention, there is provided a method for manufacturing the solid-junction photoelectric conversion element module according to [5], the method includes: a step of forming the first conductive layer of the first photoelectric conversion element, and the first conductive layer of the second photoelectric conversion element which is spaced away from the first conductive layer of the first photoelectric conversion element on the base material; a step of forming a continuous power generation layer including a perovskite layer over the first conductive layer of the first photoelectric conversion element and the first conductive layer of the second photoelectric conversion element; a step of forming the second conductive layer of the first photoelectric conversion element and the second conductive layer of the second photoelectric conversion element, which is spaced away from the second conductive layer of the first photoelectric conversion element, on the power generation layer; and a step of forming the connection portion by pressing the compression material to an end of the second conductive layer of the first photoelectric conversion element between the second conductive layer of the first photoelectric conversion element and the second conductive layer of the second photoelectric conversion element, and pressing the compression material until the end, which is pressed and recessed by the compression material, penetrates through the power generation layer and further comes into contact with the first conductive layer of the second photoelectric conversion element.

### Advantageous Effects of Invention

According to the aspects of the invention, it is possible to provide a solid-junction photoelectric conversion element module including a series connection structure of which a manufacturing process can be simplified, and a method for manufacturing the solid-junction photoelectric conversion element module.

### Brief Description of Drawings

FIG. 1 is a plan view of a solid-junction photoelectric conversion element module according to a first embodiment of the invention.
FIG. 2 is a cross-sectional view taken along line A-A in the solid-junction photoelectric conversion element module according to the first embodiment of the invention.
FIG. 3 is a plan view of a solid-junction photoelectric conversion element module according to a second embodiment of the invention.
FIG. 4 is a cross-sectional view taken along line A-A in the solid-junction photoelectric conversion element module according to the second embodiment of the invention.
FIG. 5 is a plan view of a solid-junction photoelectric conversion element module according to a third embodiment of the invention.
FIG. 6 is a cross-sectional view taken along line A-A in the solid-junction photoelectric conversion element module according to the third embodiment of the invention.
FIG. 7 is a plan view of a solid-junction photoelectric conversion element module according to a fourth embodiment of the invention.
FIG. 8 is a cross-sectional view taken along line A-A in the solid-junction photoelectric conversion element module according to the fourth embodiment of the invention.
FIG. 9 is a plan view of a solid-junction photoelectric conversion element module according to a fifth embodiment of the invention.
FIG. 10 is a cross-sectional view taken along line A-A in the solid-junction photoelectric conversion element module according to the fifth embodiment of the invention.
FIG. 11 is a plan view of a solid-junction photoelectric conversion element module according to a sixth embodiment of the invention.
FIG. 12 is a cross-sectional view taken along line A-A in the solid-junction photoelectric conversion element module according to the sixth embodiment of the invention.
FIG. 13 is a plan view of a solid-junction photoelectric conversion element module according to a seventh embodiment of the invention.
FIG. 14 is a cross-sectional view taken along line A-A in the solid-junction photoelectric conversion element module according to the seventh embodiment of the invention.
FIG. 15 is a cross-sectional view showing a manufacturing process of the solid-junction photoelectric conversion element module according to the first embodiment of the invention.
FIG. 16 is a cross-sectional view showing a manufacturing process of a solid-junction photoelectric conversion element module of a comparative example.

### Description of Embodiments

Hereinafter, the invention will be described on the basis of preferred embodiments with reference to the accompanying drawings, but the invention is not limited to the embodiments.

In this specification, a "film" and a "layer" are not discriminated unless otherwise stated. In addition, a solid-junction photoelectric conversion element may be simply referred to as "photoelectric conversion element", and organic and inorganic perovskite compounds may be simply referred to as "perovskite compounds". In addition, a solid-junction photoelectric conversion element module may be simply referred to as "module".

### <<Solid-Junction Photoelectric Conversion Element Module>>

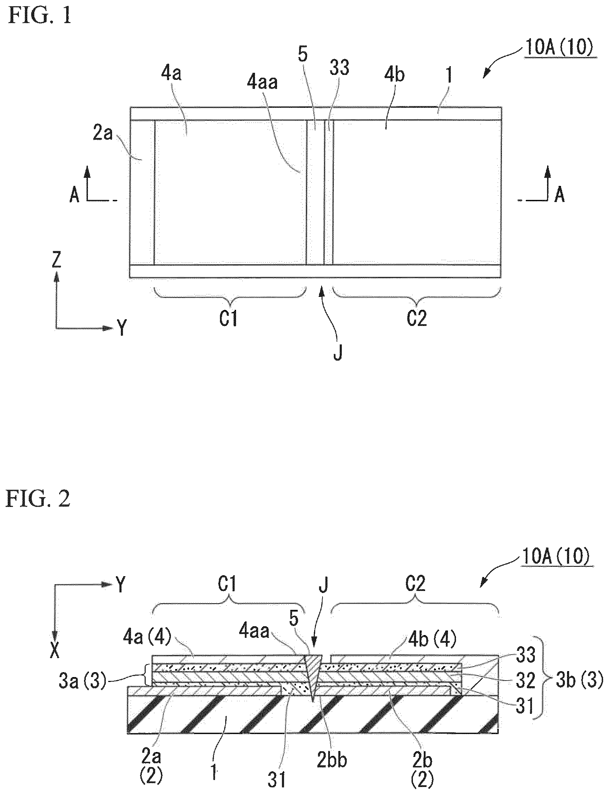

As shown in FIG. 1 to FIG. 14, a solid-junction photoelectric conversion element module according to the invention is a solid-junction photoelectric conversion element module 10 in which two or more solid-junction photoelectric conversion elements sequentially including a first conductive layer 2, a power generation layer 3 including a perovskite layer, and a second conductive layer 4 are disposed adjacently to each other on a base material 1.

The module 10 includes a connection portion J that connects a second conductive layer 4a of a first photoelectric conversion element C1 among the two or more photoelectric conversion elements, and a first conductive layer 2b of a second photoelectric conversion element C2 that is adjacent to the first photoelectric conversion element C1.

The connection portion J is in contact with a power generation layer 3a of the first photoelectric conversion element C1 and a power generation layer 3b of the second photoelectric conversion element C2.

In the cross-sectional view of the module 10, the connection portion J is in contact with a lateral surface of the power generation layer 3a of the first photoelectric conversion element C1 and a lateral surface of the power generation layer 3b of the second photoelectric conversion element C2. According to this, a structure, in which the connection portion J is interposed between the lateral surface of the first photoelectric conversion element C1 and the lateral surface of the second photoelectric conversion element C2, is obtained. In other words, a structure, in which a gap (groove) between the lateral surface of the first photoelectric conversion element C1 and the lateral surface of the second photoelectric conversion element C2 is filled with the connection portion J, is obtained, and a substantial vacancy does not exist in the gap.

### [First Embodiment]

A module 10A according to the first embodiment of the invention includes the connection portion J between the first photoelectric conversion element C1 and the second photoelectric conversion element C2.

The connection portion J is formed from a conduction material 5 that electrically connects the second conductive layer 4a of the first photoelectric conversion element C1 and the first conductive layer 2b of the second photoelectric conversion element C2.

The conduction material 5 is disposed between the first photoelectric conversion element C1 and the second photoelectric conversion element C2 along a thickness direction (X direction) of the photoelectric conversion elements C1 and C2.

When the connection portion J is seen from a cross-section (FIG. 2) that is cut along a thickness direction (X-Y direction) of the photoelectric conversion elements, the first photoelectric conversion element C1 and the second photoelectric conversion element C2 include the base material 1 that is common thereto, the first conductive layers 2 of the photoelectric conversion elements are spaced away from each other, and the second conductive layers 4 of the photoelectric conversion elements are spaced away from each other. According to this, the first photoelectric conversion element C1 and the second photoelectric conversion element C2 are compartmented.

In addition, the conduction material 5 is not in contact with a first conductive layer 2a of the first photoelectric conversion element C1 and a second conductive layer 4b of the second photoelectric conversion element C2 for the compartment.

When referring to FIG. 1, the compartment becomes further clear. FIG. 1 is a plan view of the module 10A. The second conductive layer 4a of the first photoelectric conversion element C1 and the second conductive layer 4b of the second photoelectric conversion element C2 are spaced away from each other, and a P-type semiconductor layer 33 is exposed therebetween. The conduction material 5 that constitutes the connection portion J is continuously disposed along a space between the first photoelectric conversion element C1 and the second photoelectric conversion element C2. In other words, the conduction material 5 as a continuous member is disposed along a side that is formed by an end 4aa of the second conductive layer 4a of the first photoelectric conversion element C1 (along a Z direction).

In the cross-section in FIG. 2, the conduction material 5 that connects the second conductive layer 4a and the first conductive layer 2b in series is in contact with the power generation layer 3a of the first photoelectric conversion element C1 and the power generation layer 3b of the second photoelectric conversion element C2. Since the contact exists, a leakage current may occur between the power generation layer 3a of the first photoelectric conversion element C1 and the power generation layer 3b of the second photoelectric conversion element C2. However, actually, the leakage current does not become a significant problem in practical use. As the reason for this, the following configuration can be exemplified. Specifically, a photoelectric current main path, which includes the second conductive layer 4a, the conduction material 5, and the first conductive layer 2b, is constituted by a conductive material having conductivity higher than that of a semiconductor material of the power generation layer 3. That is, even though the leakage current occurs, the majority of generated currents flow through the main path.

The power generation layer 3 includes an optionally provided N-type semiconductor layer (block layer) 31, a perovskite layer (light absorbing layer) 32, and an optionally provided P-type semiconductor layer 33 which are sequentially laminated on the first conductive layer 2.

The N-type semiconductor layer 31 is not an essential configuration, but it is preferable that the N-type semiconductor layer 31 is disposed between the first conductive layer 2 and the perovskite layer 32.

The P-type semiconductor layer 33 is not an essential configuration, but it is preferable that the P-type semiconductor layer 33 is disposed between the second conductive layer 4 and the perovskite layer 32.

When at least one of the N-type semiconductor layer 31 and the P-type semiconductor layer 33 is disposed, loss of an electromotive force is prevented, and thus photoelectric conversion efficiency is improved.

From the viewpoint of obtaining the above-described effect, it is preferable that the N-type semiconductor layer 31 and the P-type semiconductor layer 33 are non-porous dense layers.

As long as the relative order of the respective layers which constitute the power generation layer 3 is maintained, another layer may be interposed over or below any one layer in the power generation layer 3 in a range not deteriorating the gist of the invention. From the viewpoints of reducing internal resistance of the first photoelectric conversion elements C1 and C2, and raising the photoelectric conversion efficiency, it is preferable that the P-type semiconductor layer 33 is formed on a surface of the perovskite layer 32, and the second conductive layer 4 is formed on a surface of the P-type semiconductor layer 33.

Hereinafter, the respective layers will be sequentially described.

### <Base Material 1>

The kind of the base material 1 is not particularly limited, and examples thereof include a transparent base material that is used in a photoelectrode of a solar cell in the related art. Examples of the transparent base material include a substrate formed from glass or a synthetic resin, a flexible film formed from a synthetic resin, and the like.

In a case where a material of the transparent base material is a synthetic resin, example of the synthetic resin include a polyacrylic resin, a polycarbonate resin, a polyester resin, a polyimide resin, a polystyrene resin, a polyvinyl chloride resin, a polyamide resin, and the like. Among these, from the viewpoint of manufacturing a solar cell that is thin, light, and flexible, the polyester resin is preferable, and polyethylene naphthalate (PEN) or polyethylene terephthalate (PET) is more preferable.

A combination of the thickness and the material of the base material 1 is not particularly limited, and examples thereof include a glass substrate having a thickness of 1 mm to 10 mm, a resin film having a thickness of 0.01 mm to 3 mm, and the like.

### <First Conductive Layer 2>

A material of the first conductive layer 2 is not particularly limited. For example, any one or more kinds of metals selected from the group consisting of gold, silver, copper, aluminum, tungsten, nickel, and chromium are suitable.

Examples of the above-described materials include oxides such as ITO, FTO, ATO, SnO₂, and ZnO, carbon materials, polymer materials, and the like.

The thickness of the first conductive layer 2 is not particularly limited. For example, the thickness is preferably 10 nm to 100 nm.

Furthermore, the thickness in this specification is obtained as follows. A cross-section of the solid-junction photoelectric conversion element in a thickness direction is observed with an electron microscope, the thickness of arbitrary 10 sites as a measurement target is measured, and the thickness is obtained as an arithmetic average value of respective thicknesses.

### <N-Type Semiconductor Layer 31>

An N-type semiconductor that constitutes the N-type semiconductor layer 31 is not particularly limited, and examples thereof include oxide semiconductors such as ZnO, TiO₂, SnO, IGZO, and SrTiO₃ which are excellent in electron conductivity. Among these, TiO₂ is preferable in consideration of particularly excellent electron conductivity.

The kind of the N-type semiconductor that constitutes the N-type semiconductor layer 31 may be one kind, or two or more kinds.

The number of layers of the N-type semiconductor layer 31 may be one layer or two or more layers.

A total thickness of the N-type semiconductor layer 31 is not particularly limited. For example, the total thickness may be approximately 1 nm to 1 µm. When the total thickness is 1 nm or greater, the above-described loss prevention effect is sufficiently obtained, and when the total thickness is 1 µm or less, it is possible to limit the internal resistance to a low value.

### <Perovskite Layer 32>

The perovskite layer 32 is a layer that contains a perovskite compound. The perovskite layer 32 may be formed from the perovskite compound alone, or may include an underlying layer (not shown) at a part in the layer or at the entirety thereof. The underlying layer is a layer that structurally supports the perovskite layer 32.

The thickness of the perovskite layer 32 is not particularly limited. For example, the thickness is preferably 10 nm to 10 µm, more preferably 50 nm to 1 µm, and still more preferably 100 nm to 0.5 µm.

When the thickness is equal to or greater than the lower limit of the above-described range, light absorption efficiency in the perovskite layer 32 is enhanced, and thus more excellent photoelectric conversion efficiency is obtained.

When the thickness is equal to or less than the upper limit of the above-described range, efficiency in which photoelectrons generated in the perovskite layer 32 reach the first conductive layer 2 is enhanced, and thus more excellent photoelectric conversion efficiency is obtained.

The thickness of the underlying layer, which may be included in the perovskite layer 32, is not particularly limited. For example, with respect to the total thickness of the perovskite layer 32, 20% to 100% is preferable, and 30% to 80% is more preferable. Here, the thickness of the underlying layer is a thickness from a surface of the N-type semiconductor layer 31.

The kind of the perovskite compound is not particularly limited, and a perovskite compound that is used in a known solar cell is applicable. In addition, it is preferable that the perovskite compound has a crystal structure and exhibits light absorption due to band gap excitation in the same manner as in a typical compound semiconductor. For example, it is known that CH₃NH₃PbI₃ that is a known perovskite compound has an absorption coefficient (cm⁻¹) per unit thickness which is higher by one digit in comparison to a sensitizing dye of a dye-sensitized solar cell.

It is preferable that a material of the underlying layer is an N-type semiconductor and/or an insulator.

The underlying layer may be a porous film or a non-porous dense film, and the porous film is preferable. It is preferable that the perovskite compound is carried due to a porous structure of the underlying layer. Even in a case where the underlying layer is the dense film, it is preferable that the perovskite compound is contained in the dense film. It is preferable that the dense film is formed from an N-type semiconductor.

The kind of the N-type semiconductor that can constitute the underlying layer is not particularly limited, and a known N-type semiconductor is applicable. Examples thereof include an oxide semiconductor that constitutes a photoelectrode of a dye-sensitized solar cell in the related art. Specific examples thereof include oxide semiconductors such as titanium oxide (TiO₂), zinc oxide (ZnO), tin oxide (SnO, SnO₂), IGZO, and strontium titanate (SrTiO₃) which are excellent in electron conductivity. In addition, compound semiconductors such as Si, Cd, and ZnS which are doped with a penta-valent element is also applicable. Among these, titanium oxide is preferable in consideration of excellent electron conductivity.

The N-type semiconductor that forms the underlying layer may be one kind or two or more kinds.

The kind of the insulator that can constitute the underlying layer is not particularly limited, and a known insulator is applicable. Examples thereof include an oxide that constitutes an insulating layer of a semiconductor device in the related art. Specific examples thereof include zirconium dioxide, silicon dioxide, aluminum oxide (AlO, Al₂O₃), magnesium oxide (MgO), nickel oxide (NiO), and the like. Among these, aluminum (III) oxide (Al₂O₃) is more preferable.

The insulator that constitutes the underlying layer may be one kind or two or more kinds.

### <P-Type Semiconductor Layer 33>

The P-type semiconductor layer 33 that is formed on the surface of the perovskite layer 32 is constituted by a P-type semiconductor. When the P-type semiconductor layer 33 having holes is disposed between the perovskite layer 32 and the second conductive layer 4, it is possible to suppress occurrence of a reverse current, and thus efficiency in which electrons migrate from the second conductive layer 4 to the perovskite layer 32 is raised. As a result, photoelectric conversion efficiency and a voltage are raised.

The kind of the P-type semiconductor is not particularly limited, and may be an organic material or an inorganic material. For example, a P-type semiconductor which is used for a hole transport layer of a known solar cell is applicable. Examples of the organic material include 2,2',7,7'-tetrakis (N,N-di-p-methoxyphenilamine)-9,9'-spirobifluorene (abbreviation: spiro-OMeTAD), poly(3-hexylthiophene) (abbreviation: P3HT), polytriarylamine (abbreviation: PTAA), and the like.

Examples of the inorganic material include copper compounds such as CuI, CuSCN, CuO, and Cu₂O, nickel compounds such as NiO, and the like.

The thickness of the P-type semiconductor layer 33 is not particularly limited. For example, the thickness is preferably 1 nm to 1000 nm, and more preferably 5 nm to 500 nm, and still more preferably 30 nm to 500 nm.

When the thickness is equal to or greater than the lower limit of the above-described range, it is possible to obtain a high electromotive force.

When the thickness is equal to or less than the upper limit of the above-described range, it is possible to further reduce internal resistance.

### <Second Conductive Layer 4>

A material of the second conductive layer 4 is not particularly limited. For example, any one or more kinds of metals selected from the group consisting of gold, silver, copper, aluminum, tungsten, nickel, and chromium are suitable.

Examples of the above-described material include oxides such as ITO, FTO, ATO, SnO₂, and ZnO, carbon materials, polymer materials, and the like.

The thickness of the second conductive layer 4 is not particularly limited. For example, the thickness is preferably 10 nm to 100 nm.

### <Conduction Material 5>

A conductive material that constitutes the conduction material 5 is not particularly limited, and examples thereof include metal materials such as Cu, Fe, Au, Al, Ni, and SUS.

It is preferable that a shape of the conduction material 5 is a shape conforming to a boundary between the first photoelectric conversion element C1 and the second photoelectric conversion element C2, that is, a shape conforming to a longitudinal direction of an exposed portion of the P-type semiconductor layer 33 between both the photoelectric conversion elements C1 and C2. The longitudinal direction of the conduction material 5 having the shape conforms to the depth direction of the cross-sectional view of FIG. 2, that is, the Z direction in FIG. 1.

The conduction material 5 may have or may not have a tapered shape that becomes gradually thinner toward the thickness direction (X direction) of the module 10.

As a cross-sectional shape of the conduction material 5 in a direction perpendicular to the longitudinal direction (Z direction), for example, a V-shape (inverted triangle), a V-shaped, and the like are preferable. A V-shaped valley as the cross-sectional shape may be a cavity (hollow), or solid.

The conduction material 5 of the module 10A is a metal blade body (edged tool) having a tapered shape that becomes gradually thinner toward the thickness direction (X direction).

### «Power Generation of Solid-Junction Photoelectric Conversion Element Module 10»

In the second photoelectric conversion element C2, when the perovskite layer 32 absorbs light, photoelectrons and holes are generated in the layer. The photoelectrons are accommodated in the N-type semiconductor layer 31, and migrate to an operation electrode (positive electrode) that is constituted by the first conductive layer 2b. On the other hand, the holes migrate to a counter electrode (negative electrode) that is constituted by the second conductive layer 4b through the P-type semiconductor layer 33.

The photoelectrons, which migrate to the first conductive layer 2b of the second photoelectric conversion element C2, flow to the second conductive layer 4a of the first photoelectric conversion element C1 through the connection portion J. Then, the photoelectrons flow through the power generation layer 3a and reach the first conductive layer 2a in the first photoelectric conversion element C1.

Through the series of the processes, the electrons (photoelectrons) flow from the second photoelectric conversion element C2 to the first photoelectric conversion element C1. That is, a current flows from the first photoelectric conversion element C1 to the second photoelectric conversion element C2.

The current that is generated by the module 10 can be taken out to an external circuit through an extracting electrode that is connected to the first conductive layer 2a and the second conductive layer 4b.

### <<Other Embodiments of Module>>

### [Second Embodiment]

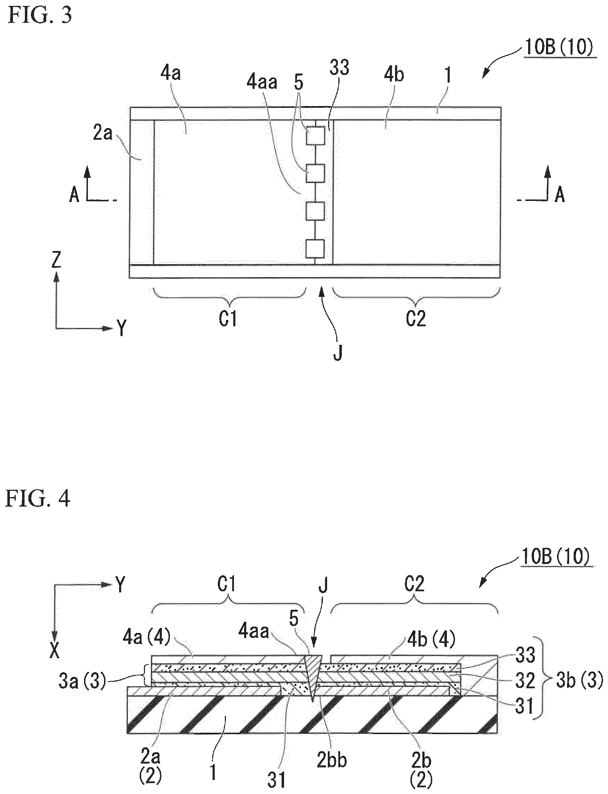

As shown in a plan view of FIG. 3, and a cross-sectional view of FIG. 4, a solid-junction photoelectric conversion element module 10B (10) according to a second embodiment of the invention has a connection type that is similar to the module 10A according to the first embodiment.

A connection portion J according to the second embodiment is constituted by a plurality of conduction materials 5 which connect a second conductive layer 4a of a first photoelectric conversion element C1 and a first conductive layer 2b of a second photoelectric conversion element C2 in series.

The plurality of conduction materials 5 provided in the module 10B are a plurality of pin bodies which are disposed to be spaced away from each other in a direction (Z direction) conforming to a side formed by an end 4aa of the second conductive layer 4a between the photoelectric conversion elements C1 and C2.

The module 10A according to the first embodiment includes the blade body that is continuous in the Z direction, but the module 10B of this embodiment includes the plurality of pin bodies obtained by dividing the blade body in the Z direction.

The pin bodies may have or may not have a tapered shape that gradually becomes thin toward the thickness direction (X direction) of the module 10B, but it is preferable that the pin bodies have the tapered shape.

A cross-sectional shape of the pin bodies in a direction perpendicular to the X direction is not particularly limited, and examples thereof include a circle, an ellipse, a triangle, a rectangle, and other polygons. The cross-sectional shape of the pin bodies may be hollow or solid.

Examples of the pin bodies include conductive members such as a nail, a needle, a wedge, and a thin rod.

In the cross-sectional view of FIG. 4, the conduction material 5 is in contact with a power generation layer 3a of the first photoelectric conversion element C1 and a power generation layer 3b of the second photoelectric conversion element C2. Since the contact exists, a leakage current may occur between the power generation layer 3a of the first photoelectric conversion element C1 and the power generation layer 3b of the second photoelectric conversion element C2. However, actually, the leakage current does not become a significant problem in practical use. The reason for this is the same as in the module 10A according to the first embodiment.

In the plan view of FIG. 3, the second conductive layer 4a of the first photoelectric conversion element C1 and a second conductive layer 4b of the second photoelectric conversion element C2 are spaced away from each other, and a P-type semiconductor layer 33 is exposed therebetween. The conduction material 5 that constitutes the connection portion J is discontinuously disposed along a space between the first photoelectric conversion element C1 and the second photoelectric conversion element C2. In other words, the plurality of pin bodies which constitute the conduction material 5 are disposed to be spaced away from each other along the side that is formed by the end 4aa of the second conductive layer 4a (along the Z direction).

As is clear from FIG. 3 and FIG. 4, the pin bodies separate the power generation layer 3a of the first photoelectric conversion element C1 and the power generation layer 3b of the second photoelectric conversion element C2 from each other. However, since the pin bodies are scattered along the Z direction, a portion in which the power generation layer 3a of the first photoelectric conversion element C1 and the power generation layer 3b of the second photoelectric conversion element C2 are continuous exists. A leakage current may occur at the portion, but the leakage current does not become a significant problem in practical use. As the reason for this, the following configuration can be exemplified. Specifically, a photoelectric current main path, which includes the second conductive layer 4a, the conduction material 5, and the first conductive layer 2b, is constituted by a conductive material having conductivity higher than that of a semiconductor material of the power generation layer 3. That is, even though the leakage current occurs, the majority of generated currents flow through the main path.

### [Third Embodiment]

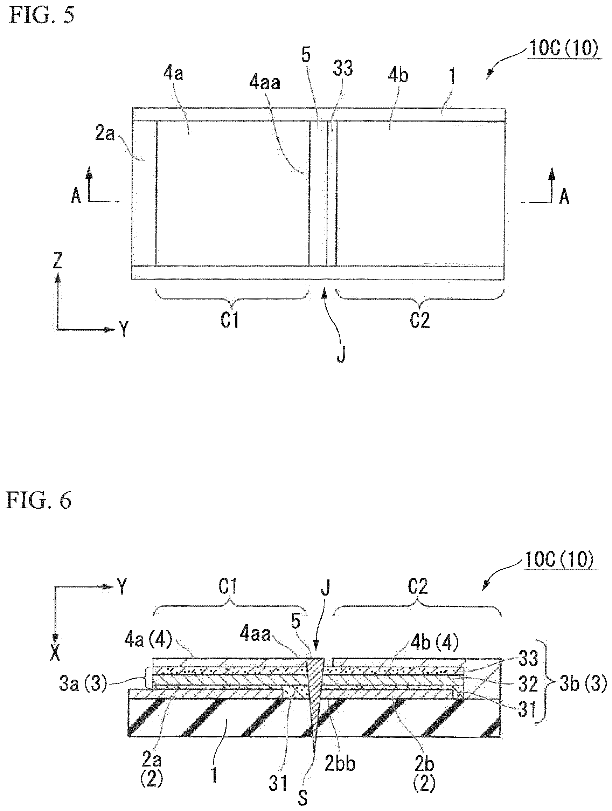

As shown in FIG. 5 and FIG. 6, a solid-junction photoelectric conversion element module 10C (10) according to a third embodiment of the invention has a connection type that is similar to the module 10A according to the first embodiment. The module 10C is different from the module 10A in that a tip end S of the blade body that constitutes the conduction material 5 penetrates through the base material 1 in the X direction and protrudes to the outside. Since the tip end S protrudes in this manner, the conduction material 5 is fixed to the base material 1 in a more stable manner. The other configurations are the same as in the module 10A, and thus a description thereof will be omitted.

### [Fourth Embodiment]

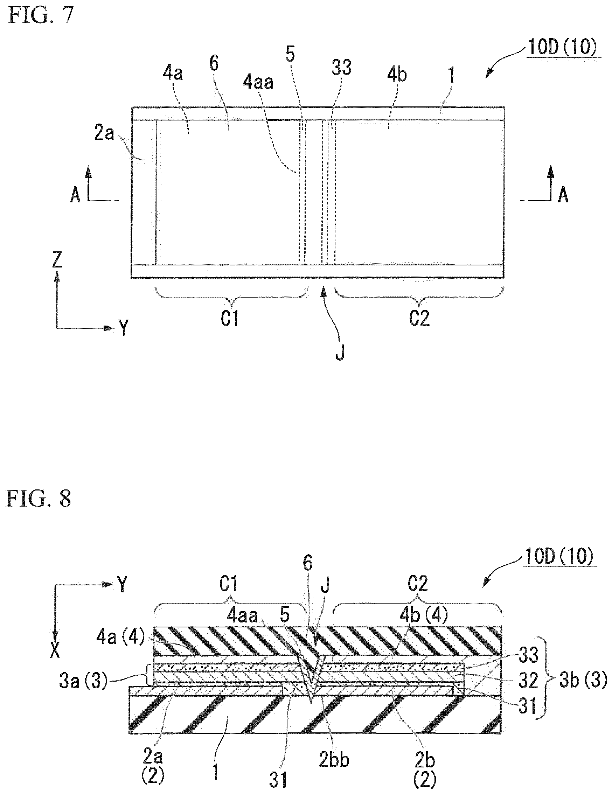

As shown in FIG. 7 and FIG. 8, a solid-junction photoelectric conversion element module 10D (10) according to a fourth embodiment of the invention has a connection type that is similar to the module 10A according to the first embodiment. The module 10D is different from the module 10A in that the inverted triangle (V-shape) of the cross-section of the blade body, which constitutes the conduction material 5, in the X direction is set to a V-shape. In addition, the module 10D is different from the module 10A in that the V-shaped valley is filled with a support material 6 constituted by an insulating material. The support material 6 covers an upper surface (the second conductive layer 4a, the connection portion J, and the second conductive layer 4b) of the module 10D in a range from the first photoelectric conversion element C1 to the second photoelectric conversion element C2. Due to the covering structure, the connection portion J is fixed in a more stable manner, and the upper surface of the module 10D is structurally reinforced. The other configurations are the same as in the module 10A, and thus a description thereof will be omitted.

A material that constitutes the support material 6 is not particularly limited as long as the material is an insulating material, and a transparent material is preferable. Examples of the material include a synthetic resin, a hard rubber, ceramics, glass, and the like. For example, the thickness of the support material 6 may be 1 µm to 1000 µm.

### [Fifth Embodiment]

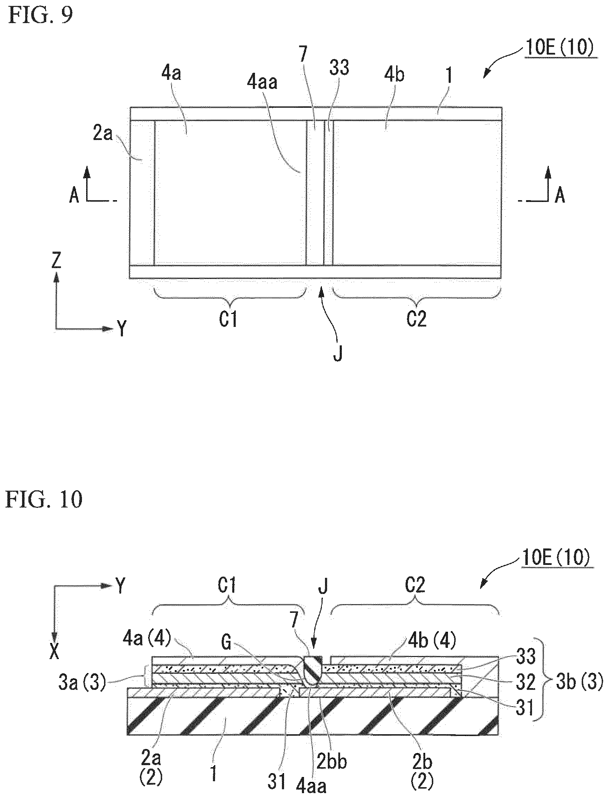

As shown in FIG. 9 and FIG. 10, a solid-junction photoelectric conversion element module 10E (10) according to a fifth embodiment of the invention includes a connection portion J between a first photoelectric conversion element C1 and a second photoelectric conversion element C2 which are adjacent to each other.

The connection portion J further includes an extension portion G in which an end 4aa of a second conductive layer 4a of the first photoelectric conversion element C1 extends in a state in which the end 4aa is in contact with a lateral surface of the first photoelectric conversion element C1 in a thickness direction (X direction), and which is electrically connected to a first conductive layer 2b of the second photoelectric conversion element C2.

The connection portion J further includes a compression material 7 that is disposed along the X direction in which the extension portion G extends. The compression material 7 comes into close contact with the extension portion G.

When the connection portion J is seen from a cross-section (FIG. 10) that is cut along a thickness direction (X-Y direction) of the photoelectric conversion elements, the first photoelectric conversion element C1 and the second photoelectric conversion element C2 include a base material 1 that is common thereto, the first conductive layers 2 of the photoelectric conversion elements are spaced away from each other, and the second conductive layers 4 of the photoelectric conversion elements are spaced away from each other. According to this, the first photoelectric conversion element C1 and the second photoelectric conversion element C2 are compartmented. In addition, the end 4aa of the second conductive layer 4a that constitutes the extension portion G is not in contact with the first conductive layer 2a of the first photoelectric conversion element C1 and the second conductive layer 4b of the second photoelectric conversion element C2 for the compartment.

When referring to FIG. 9, the compartment becomes further clear. FIG. 9 is a plan view of the module 10E. The second conductive layer 4a of the first photoelectric conversion element C1 and the second conductive layer 4b of the second photoelectric conversion element C2 are spaced away from each other, and a P-type semiconductor layer 33 is exposed therebetween. The connection portion J is continuously disposed along a space between the first photoelectric conversion element C1 and the second photoelectric conversion element C2. In other words, the connection portion J formed as a continuous member is continuously disposed along a side formed by the end 4aa of the second conductive layer 4a of the first photoelectric conversion element C1 (along the Z direction).

In the cross-section shown in FIG. 10, the extension portion G that connects the second conductive layer 4a and the first conductive layer 2b in series is in contact with a power generation layer 3a of the first photoelectric conversion element C1. On the other hand, the extension portion G is not in contact with a P-type semiconductor layer 33 and a perovskite layer 32 which constitutes a power generation layer 3b of the second photoelectric conversion element C2.

At least a part of the end 4aa that constitutes the extension portion G is in contact with not only the first conductive layer 2b but also an N-type semiconductor layer 31 that constitutes the second photoelectric conversion element C2. Since the contact exists, a leakage current may occur between the power generation layer 3a of the first photoelectric conversion element C1 and the power generation layer 3b of the second photoelectric conversion element C2. However, actually, the leakage current does not become a significant problem in practical use. As the reason for this, the following configuration can be exemplified. Specifically, a photoelectric current main path, which includes the second conductive layer 4a, the conduction material 5, and the first conductive layer 2b, is constituted by a conductive material having conductivity higher than that of a semiconductor material of the power generation layer 3. That is, even though the leakage current occurs, the majority of generated currents flow through the main path.

In the cross-section shown in FIG. 10, the compression material 7, which is provided adjacently to the extension portion G, is in contact with lateral surfaces of the extension portion G and the power generation layer 3b of the second photoelectric conversion element C2. According to this, a structure, in which the extension portion G and the compression material 7 are interposed between the lateral surface of the first photoelectric conversion element C1 and the lateral surface of the second photoelectric conversion element C2, is obtained. In other words, a structure, in which a gap (groove) between the lateral surface of the first photoelectric conversion element C1 and the lateral surface of the second photoelectric conversion element C2 is filled with the extension portion G and the compression material 7, is obtained, and a substantial vacancy does not exist in the gap.

A material that constitutes the compression material 7 is not particularly limited, and may be a conductive material or an insulating material. However, the insulating material is preferable. When the compression material 7 is the insulating material, an insulation property of the power generation layer 3a of the first photoelectric conversion element C1 and the power generation layer 3b of the second photoelectric conversion element C2 is raised, and thus it is possible to reduce occurrence of a leakage current. Furthermore, in a case where the compression material 7 is the conductive material, as in the module 10A according to the first embodiment, even though the leakage current occurs, the leakage current does not become a significant problem in practical use.

Examples of the insulating material that constitutes the compression material 7 include a synthetic resin, a hard rubber, ceramics, glass, and the like.

Examples of the conductive material that constitutes the compression material 7 include metal materials such as Cu, Fe, Au, Al, Ni, and SUS.

It is preferable that a shape of the compression material 7 is a shape conforming to a boundary between the first photoelectric conversion element C1 and the second photoelectric conversion element C2, that is, a shape conforming to a longitudinal direction of an exposed portion of the P-type semiconductor layer 33.

The longitudinal direction of the compression material 7 having the shape conforms to a depth direction in the cross-sectional view of FIG. 10, that is, the Z direction in FIG. 9.

The compression material 7 may have or may not have a tapered shape that becomes gradually thinner toward the thickness direction (X direction) of the module 10E. As a shape of a cross-section of the compression material 7 in a direction perpendicular to the longitudinal direction (Z direction), for example, a U-shape or a V-shape is preferable, and the U-shape is more preferable. In the U-shaped, there is an advantage that it is easier to fix the end 4aa of the second conductive layer 4a in a state in which the end 4aa is in contact with the first conductive layer 2b. A U-shaped or V-shaped valley as the cross-sectional shape may be a cavity (hollow), or solid.

The shape of the compression material 7 in this embodiment is a shape with which a gap between the first photoelectric conversion element C1 and the second photoelectric conversion element C2 is filled, and a shape obtained by rounding off a blade (tip end in the X direction) of the blade body.

The other structures are the same as in the module 10A, and thus a description thereof will be omitted.

### [Sixth Embodiment]

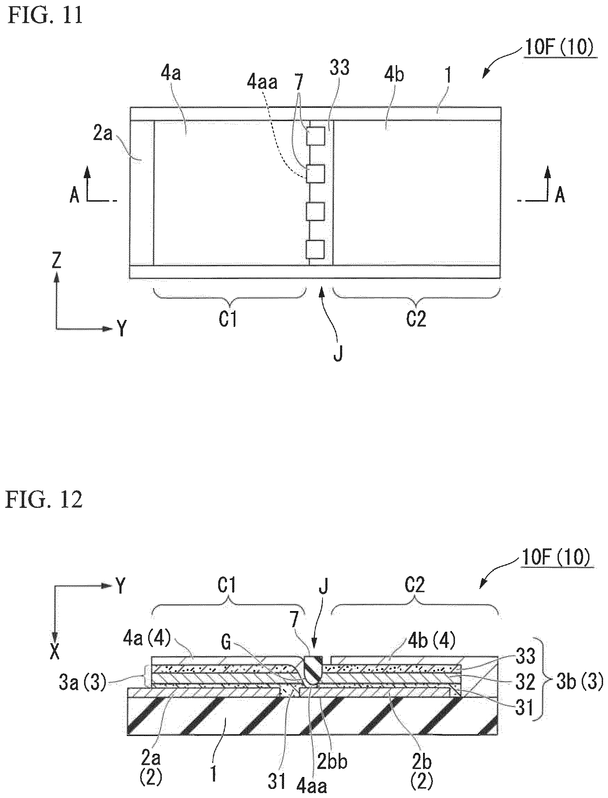

As shown in a plan view of FIG. 11 and a cross-sectional view of FIG. 12, a solid-junction photoelectric conversion element module 10F (10) according to a sixth embodiment of the invention has a connection type that is similar to the module 10E according to the first embodiment.

In a cross-sectional view of FIG. 12, a connection portion J includes a plurality of extension portions G in which an end 4aa of a second conductive layer 4a of a first photoelectric conversion element C1 extends in a state in which the end 4aa is in contact with a lateral surface of the first photoelectric conversion element C1 in a thickness direction (X direction), and which are connected to a first conductive layer 2b of the second photoelectric conversion element C2.

In addition, a compression material 7, which is disposed adjacently to each of the plurality of extension portions G, is inserted in a thickness direction (X direction) of respective photoelectric conversion elements. A tip end of the compression material 7, which is inserted, is fixed in a state in which the end 4aa of the second conductive layer 4a that constitutes the extension portion G is in contact with the first conductive layer 2b of the second photoelectric conversion element C2.

In the plan view of FIG. 11, the plurality of connection portions J, which are provided in the module 10F, are discontinuously disposed along a space between the first photoelectric conversion element C1 and the second photoelectric conversion element C2. In other words, the plurality of connection portions J are disposed to be spaced away from each other along a side that is formed by the end 4aa of the second conductive layer 4a (along the Z direction).

As is clear from FIG. 11 and FIG. 12, the individual compression materials 7 separate a power generation layer 3a of the first photoelectric conversion element C1 and a power generation layer 3b of the second photoelectric conversion element C2 from each other. However, the individual connection portions J are discontinuous (scattered) along the Z direction, and thus a portion in which the power generation layer 3a of the first photoelectric conversion element C1 and the power generation layer 3b of the second photoelectric conversion element C2 are continuous exists. A leakage current may occur at the portion, but the leakage current does not become a significant problem in practical use. The reason for this is also the same as in the module 10B.

The other structures are the same as in the module 10E, and thus a description thereof will not be repeated.

### [Seventh Embodiment]

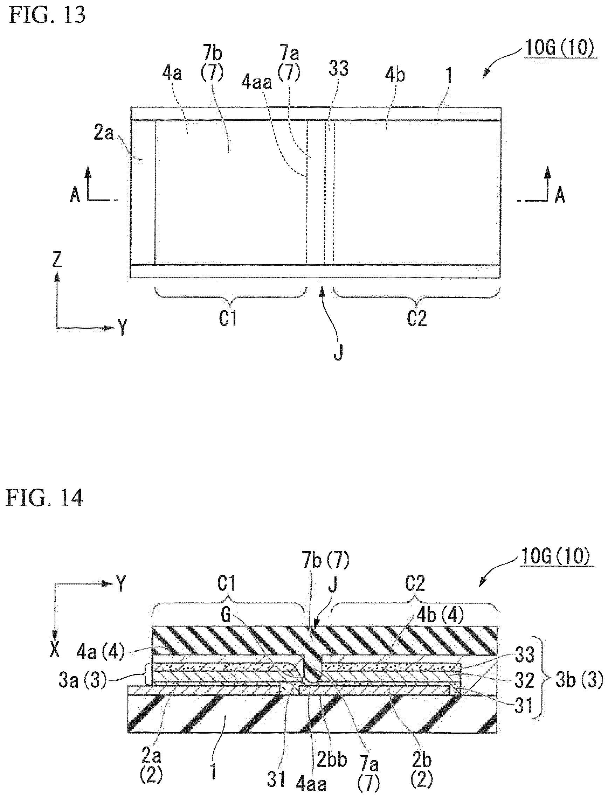

As shown in FIG. 13 and FIG. 14, a solid-junction photoelectric conversion element module 10G (10) according to a seventh embodiment of the invention has a connection type that is similar to the module 10E according to the fifth embodiment. The module 10G is different from the module 10E in that a support material 7b that is formed form an insulating material, which covers an upper surface (a second conductive layer 4a, a connection portion J, and a second conductive layer 4b) of the module 10G, is provided in a range from a first photoelectric conversion element C1 to a second photoelectric conversion element C2. In this embodiment, the support material 7b and the compression material 7a are formed from the same insulating material, and constitute an integrated member. Insulating materials, which constitute the support material 7b and the compression material 7a, may be the same or different, but it is preferable that the insulating materials are the same as each other from the viewpoint of enhancing integrity. A description of the support material 7b is the same as in the support material 6 of the module 10D, and thus a description thereof will be omitted. The other configurations are the same as in the module 10E, and thus a description thereof will be omitted.

### [Eighth Embodiment]

The module 10G according to the seventh embodiment is provided with the support material 6 that covers the upper surface of the module 10E in addition to the module 10E according to the fifth embodiment.

Similarly, an eighth embodiment (not shown), in which the support material 6 that covers the upper surface of the module 10F is provided in addition to the module 10F according to the sixth embodiment, can be exemplified as an example of the invention.

### [Ninth Embodiment]

The module 10G according to the seventh embodiment of the invention is provided with the support material 6 that covers the upper surface of the module 10E in addition to the module 10E according to the fifth embodiment.

Similarly, a ninth embodiment (not shown), in which the support material 6 that covers the upper surface of the module 10B is provided in addition to the module 10B according to the second embodiment, can be exemplified as an example of the invention.

### «Method for Manufacturing Solid-Junction Photoelectric Conversion Element Module»

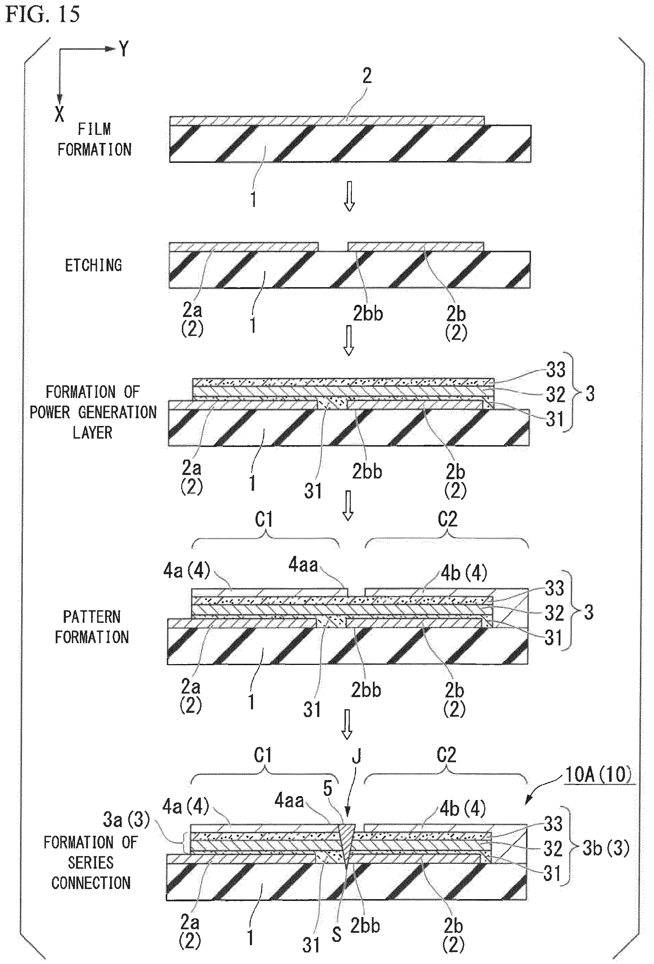

As shown in FIG. 15, a first aspect of a method for manufacturing the module 10 according to the invention includes a step of forming the first conductive layer 2a of the first photoelectric conversion element C1, and the first conductive layer 2b of the second photoelectric conversion element C2 which is spaced away from the first conductive layer 2a of the first photoelectric conversion element C1 on the base material 1, a step of forming a continuous power generation layer 3 over the first conductive layer 2a of the first photoelectric conversion element C1 and the first conductive layer 2b of the second photoelectric conversion element C2, a step of forming the second conductive layer 4a of the first photoelectric conversion element C1 and the second conductive layer 4b of the second photoelectric conversion element C2, which is spaced away from the second conductive layer 4a, on the continuous power generation layer 3, and a step of forming the connection portion J by inserting the conduction material 5 between the second conductive layer 4a of the first photoelectric conversion element C1 and the second conductive layer 4b of the second photoelectric conversion element C2 from the second conductive layer 4a side of the first photoelectric conversion element C1, and pressing the conduction material 5 until the conduction material 5 penetrates through the power generation layer 3 and comes into contact with the first conductive layer 2b of the second photoelectric conversion element C2.

A second aspect of the method for manufacturing the module 10 according to the invention includes a step of forming the first conductive layer of the first photoelectric conversion element, and the first conductive layer of the second photoelectric conversion element which is spaced away from the first conductive layer of the first photoelectric conversion element on the base material, a step of forming a continuous power generation layer over the first conductive layer of the first photoelectric conversion element and the first conductive layer of the second photoelectric conversion element, a step of forming the second conductive layer of the first photoelectric conversion element and the second conductive layer of the second photoelectric conversion element, which is spaced away from the second conductive layer of the first photoelectric conversion element, on the continuous power generation layer, and a step of forming the connection portion by pressing the compression material to an end of the second conductive layer of the first photoelectric conversion element between the second conductive layer of the first photoelectric conversion element and the second conductive layer of the second photoelectric conversion element, and pressing the compression material until the end, which is pressed and recessed by the compression material, penetrates through the power generation layer and further comes into contact with the first conductive layer of the second photoelectric conversion element.

### [First Embodiment]

A description will be given of an example of the method for manufacturing the module 10A shown in FIG. 1 and FIG. 2 with reference to FIG. 15.

First, the first conductive layer 2 is formed on the base material 1 by a physical vapor deposition method, and forms the first conductive layer 2a and the first conductive layer 2b, which are spaced away from each other, in a pattern corresponding to compartment of the first photoelectric conversion element C1 and the second photoelectric conversion element C2. In this step, the base material 1 is exposed at a site at which the first conductive layer 2a and the first conductive layer 2b are spaced away from each other.

Subsequently, the N-type semiconductor layer 31, the perovskite layer 32, and the P-type semiconductor layer 33 are sequentially laminated on the first conductive layer 2a and the first conductive layer 2b to form the power generation layer 3. The surface of the base material 1, which is left in the exposed state at the site at which the first conductive layer 2a and the first conductive layer 2b are spaced away from each other in the previous step, is covered with the N-type semiconductor layer 31 that is formed at this step.

Subsequently, the second conductive layer 4a and the second conductive layer 4b, which are spaced away from each other, are formed on the power generation layer 3 in a pattern corresponding to the compartment of the first photoelectric conversion element C1 and the second photoelectric conversion element C2. At this time, as shown in the drawing, the pattern is formed so that the end 4aa of the second conductive layer 4a is not superimposed on the first conductive layer 2a when seen from an upper side in the thickness direction (X direction).

According to the process, a laminated body, in which the first photoelectric conversion element C1 and the second photoelectric conversion element C2 are not yet connected in series, is obtained.

Subsequently, the conduction material 5 is inserted into the laminated body from an upper side of the second conductive layer 4a to form the connection portion J, thereby connecting the first photoelectric conversion element C1 and the second photoelectric conversion element C2 in series.

Through the above-described processes, it is possible to manufacture the module 10A.

Hereinafter, respective processes will be described in detail.

### <Preparation of Base Material 1>

The base material 1 can be prepared by a typical method, or a commercially available product may be used as the base material 1.

### <Formation of First Conductive Layer 2>

There is no particular limitation to a method of forming the first conductive layer 2a of the first photoelectric conversion element C1 and the first conductive layer 2b of the second photoelectric conversion element C2 on the surface of the base material 1, and a known film forming method such as a sputtering method and a vapor deposition method is applicable to the method.

After forming a series of first conductive layers 2 on the surface of the base material 1, the first conductive layer 2a and the first conductive layer 2b may be patterned by a known etching method. In addition, the first conductive layer 2a and the first conductive layer 2b, which are spaced away from each other, may be formed by placing a mask during film formation.

Here, when a clearance between the first conductive layer 2a and the first conductive layer 2b is adjusted to be lengthened during film formation, it is possible to suppress an influence of a leakage current between the power generation layer 3 of the first photoelectric conversion element C1 and the power generation layer 3 of the second photoelectric conversion element C2 to the minimum.

### <Formation ofN-Type Semiconductor Layer 31>

A series of continuous N-type semiconductor layer 31 is formed on the first conductive layer 2a of the first photoelectric conversion element C1, the first conductive layer 2b of the second photoelectric conversion element C2, and the base material 1 that is exposed between the first conductive layer 2a and the first conductive layer 2b.

A method of forming the N-type semiconductor layer 31 is not particularly limited, and examples of a known method capable of forming a dense layer formed from an N-type semiconductor in a desired thickness include a sputtering method, a vapor deposition method, a sol-gel method in which a dispersed solution containing a precursor of the N-type semiconductor is applied, and the like.

Examples of the precursor of the N-type semiconductor include titanium tetrachloride (TiCl₄), peroxotitanic acid (PTA), titanium alkoxides such as titanium ethoxide and titanium isopropoxide (TTIP), and metal alkoxides such as zinc alkoxide, alkoxysilane, and zirconium alkoxide.

### <Formation of Perovskite Layer 32>

In a case of forming the underlying layer that supports the perovskite layer 32, a method thereof is not particularly limited, and a method of forming a semiconductor layer that carries a sensitizing dye of a dye-sensitized solar cell in the related art is applicable. As a specific example, for example, paste containing particulates of an N-type semiconductor or an insulator and a binder, or a binder-free dispersed solution of the particulates is applied to a surface of the N-type semiconductor layer 31 with a doctor blade method, and the dispersed solution is dried and baked, thereby forming a porous underlying layer composed of the particulates. In addition, the particulates are sprayed to the surface of the N-type semiconductor layer 31 to form a porous or nonporous underlying layer composed of the particulates.

A method of spraying the particulates is not particularly limited, and a known method is applicable. Examples of the method include an aerosol deposition method (AD method), an electrostatic particulate coating method (electrostatic spraying method) in which the particulates are accelerated by an electrostatic force, a cold spraying method, and the like. Among the methods, when considering that velocity adjustment of the sprayed particulates is easy, adjustment of a film quality or the thickness of the underlying layer that is formed is easy, and film formation can be performed at a low temperature, the AD method is preferable.

A method of containing a perovskite compound in the underlying layer is not particularly limited, and examples thereof include a method of impregnating an underlying layer that is formed with a solution containing the perovskite compound or a precursor of the perovskite compound, a method of forming the underlying layer by using a material to which the perovskite compound is attached in advance, and the like. In addition, the two methods may be used in combination.

Examples of a method of attaching the perovskite compound to the particulates include a method in which the particulates are immersed in a raw material solution in which the perovskite compound or a precursor of the perovskite compound is dissolved, and a solvent is dried to obtain raw material particles to which a crystallized perovskite compound are attached.

A layer (upper layer), which further contains the perovskite compound, may be formed on a surface of the underlying layer. A method of forming the upper layer is not particularly limited, and the following method can be exemplified as an example. Specifically, a raw material solution in which the perovskite compound or a precursor of the perovskite compound is dissolved is applied to the surface of the underlying layer so as to impregnate the raw material solution into the underlying layer, and a solvent is dried in a state in which a solution layer composed of the solution exists on the surface in a desired thickness.

At least a part of the raw material solution that is applied to the underlying layer permeates into a porous film of the underlying layer, and crystallization proceeds in combination with drying of the solvent. According to this, the perovskite compound adheres to the inside of the porous film and is deposited therein. In addition, when the raw material solution is applied in a sufficient amount, a solvent of the raw material solution that does not permeate into the porous film is dried and forms the upper layer composed of the perovskite compound on the surface of the underlying layer. The perovskite compound that constitutes the upper layer and the perovskite compound inside the underlying layer are integrally formed and integrally constitute the perovskite layer 32.

The perovskite compound that is used in this embodiment is not particularly limited as long as the perovskite compound is capable of generating an electromotive force due to light absorption, and known perovskite compounds are applicable. Among these, a perovskite compound that is capable of forming a perovskite-type crystal, includes an organic component and an inorganic component in a single compound, and is expressed by the following composition formula (1) is preferable.

ABX₃ ... (1)

In the composition formula (1), A represents an organic cation, B represents a metal cation, and X represents a halogen ion. In a perovskite crystal structure, a B site can take octahedral coordination with respect to an X site. The reason for this is considered to be because atomic orbits of the metal cation X at the B site and the halogen ion at the X site are hybridized, and thus a valance band and a conduction band relating to photoelectric conversion are formed.

A metal relating to the metal cation that is represented by B in the composition formula (1) is not particularly limited, and examples thereof include Cu, Ni, Mn, Fe, Co, Pd, Ge, Sn, Pb, and Eu. Among these, Pb and Sn, which are capable of easily forming a high conductive band through hybridization with an atomic orbit of the halogen ion at the X site, are preferable.

The metal cation that constitutes the B site may be one kind or two or more kinds.

Halogen relating to the halogen ion represented by X in the composition formula (1) is not particularly limited, and examples thereof include F, Cl, Br, and I. Among these, Cl, Br, and I, which are capable of easily forming a high conductive band by hybridized orbit with the metal cation at the B site, are preferable.

The kind of the halogen ion that constitutes the X site may be one kind or two or more kinds.

An organic group that constitutes the organic cation represented by A in the composition formula (1) is not particularly limited, and examples thereof include an alkyl ammonium derivative and a formamidinium derivative.

The organic cation that constitutes the A site may be one kind or two or more kinds.

Examples of the organic cation that is constituted by the alkyl ammonium derivative include primary or secondary ammonium such as methyl ammonium, dimethyl ammonium, trimethyl ammonium, ethyl ammonium, propyl ammonium, isopropyl ammonium, tert-butyl ammonium, pentyl ammonium, hexyl ammonium, octyl ammonium, and phenyl ammonium, which have an alkyl group having 1 to 6 carbon atoms. Among these, the methyl ammonium is preferable when considering that a perovskite crystal is easily obtained.

Examples of the organic cation that is constituted by the formamidinium derivative include formamidinium, methyl formamidinium, dimethyl formamidinium, trimethyl formamidinium, and tetramethyl formamidinium. Among these, formamidinium is preferable when considering that the perovskite crystal is easily obtained.

Examples of a suitable perovskite compound expressed by the composition formula (1) include alkylamino lead halide such as CH₃NH₃PbI₃, CH₃NH₃PbI₃₋ₕClₕ (h represents 0 to 3), and CH₃NH₃PbI₃₋ⱼBrⱼ (j represents 0 to 3) which are expressed by the following composition formula (2).

RNH₃PbX₃ ... (2)

In the composition formula (2), R represents an alkyl group, and X represents a halogen ion. The perovskite compound having the composition formula has a wide absorption wavelength region and can absorb a wide wavelength range of solar light. Accordingly, excellent photoelectric conversion efficiency is obtained.

As the alkyl group that is represented by R in the composition formula (2), a straight-chain, a branched chain, or a cyclic saturated or unsaturated alkyl group having 1 to 6 carbon atoms is preferable, a straight-chain saturated alkyl group having 1 to 6 carbon atom is more preferable, and a methyl group, an ethyl group, or an n-propyl group is still more preferable. In a case of the suitable alkyl groups, a perovskite crystal is easily obtained.

In formation of the perovskite layer 32, examples of the precursor contained in the raw material solution include a halide (BX) that contains the metal ion at the B site and the halogen ion at the X site, and a halide (AX) that contains the organic cation at the A site and the halogen ion at the X site.

A single raw material solution containing the halide (AX) and the halide (BX) may be applied to the underlying layer, or two raw material solutions, which individually contain the halides, may be sequentially applied to the underlying layer.

A solvent of the raw material solution is not particularly limited as long as the solvent dissolves the raw material and does not dissolve the underlying layer, and examples thereof include compounds such as ester, ketone, ether, alcohol, glycol ether, amide, nitrile, carbonate, halogenated hydrocarbon, hydrocarbon, sulfone, sulfoxide, and formamide.

As an example, halogenated alkyl amine and lead halide are dissolved in a mixed solution of γ-butyrolactone (GBL) and dimethylsulfoxide (DMSO), and the solution is applied to the underlying layer and is dried. According to this, a perovskite crystal formed from the perovskite compound expressed by the composition formula (2) is obtained. In addition, as described in Non-Patent Document 2, a step of applying a solvent that does not dissolve the perovskite crystal and is compatible with GBL and DMSO, for example, toluene, chloroform, or the like onto the perovskite crystal, and performing annealing at an approximately 100°C may be additionally performed. According to the additional processing, stability of the perovskite crystal may be improved, and photoelectric conversion efficiency may be raised.

A concentration of the raw material in the raw material solution is not particularly limited, and it is preferable that the concentration is set to a certain extent exhibiting viscosity at which the raw material solution is sufficiently dissolved and is permeable into the porous film.

An application amount of the raw material solution that is applied to the underlying layer is not particularly limited. For example, it is preferable that the application amount is set to a certain extent at which the raw material solution permeates into at least a part or the entirety of porous film and the upper layer is formed on the surface of the porous film in a thickness of approximately 1 nm to 1 µm.

A method of applying the raw material solution to the underlying layer is not particularly limited, and known methods such as a gravure coating method, a bar coating method, a printing method, spraying method, a spin coating method, a dipping method, and a die coating method are applicable.

A method of drying the raw material solution applied to the underlying layer is not particularly limited, and known methods such as natural drying, drying under reduced pressure, and hot-wind drying are applicable.

A drying temperature of the raw material solution applied to the underlying layer may be a temperature at which crystallization of the perovskite compound sufficiently proceeds, and examples thereof include a range of 40°C to 150°C.

### <Formation of P-Type Semiconductor Layer 33>

A method of forming the P-type semiconductor layer 33 is not particularly limited, and examples thereof include a method of obtaining the P-type semiconductor layer 33 by preparing a solution obtained by dissolving or dispersing a P-type semiconductor in a solvent that is less likely to dissolve the perovskite compound that constitutes the perovskite layer 32, applying the solution to a surface of the perovskite layer 32, and drying the solution.

Through the above-described processes, it is possible to form the power generation layer 3 that sequentially includes the N-type semiconductor layer 31, the perovskite layer 32, and the P-type semiconductor layer 33.

### <Formation of Second Conductive Layer 4>

There is no particular limitation to a method of forming the second conductive layer 4a of the first photoelectric conversion element C1 and the second conductive layer 4b of the second photoelectric conversion element C2 on the surface of the P-type semiconductor layer 33, and known film formation methods such as a sputtering method and a vapor deposition method are applicable.

When a mask is placed during film formation, it is possible to pattern the second conductive layer 4a and the second conductive layer 4b which are spaced away from each other. At this time, when a clearance between the second conductive layer 4a and the second conductive layer 4b is adjusted to be lengthened during film formation, it is possible to suppress an influence of a leakage current between the power generation layer 3 of the first photoelectric conversion element C1 and the power generation layer 3 of the second photoelectric conversion element C2 to the minimum.

In addition, when seen from an upper side of the laminated body in the thickness direction (X direction) after pattern formation, it is preferable that the end 4aa of the second conductive layer 4a of the first photoelectric conversion element C1 is located at a position at which the end 4aa overlaps the end 2bb of the first conductive layer 2b of the second photoelectric conversion element C2. In a case of this position, it is possible to further easily form the connection portion J at the subsequent process.

### <Formation of Connection Portion J>

A blade body including a blade formed from a conductive material that constitutes the conduction material 5 is inserted into the laminated body from an upper side of the second conductive layer 4a to electrically connect the end 4aa of the second conductive layer 4a of the first photoelectric conversion element C1 and the end 2bb of the first conductive layer 2b of the second photoelectric conversion element C2 with each other by the blade body. Due to the connection, the solid-junction photoelectric conversion element module 10A, which includes the connection portion J including the conduction material 5 that connects the first photoelectric conversion element C1 and the second photoelectric conversion element C2 in series, is obtained.

In the laminated body, the P-type semiconductor layer 33 is exposed between the second conductive layer 4a and the second conductive layer 4b which are spaced away from each other. When inserting the blade body into the exposed portion, the blade portion is inserted from the vicinity of the end 4aa of the second conductive layer 4a. According to this, it is possible to easily bring the blade body into contact with the end 4aa. As the blade body is inserted (invades) into the laminated body in the thickness direction thereof, the blade body penetrates through the power generation layer 3, and reaches the end 2bb of the first conductive layer 2b. From the viewpoint of more stably fixing the blade body that constitutes the conduction material 5, it is preferable to press the blade body until a blade on a tip end S of the blade body reaches the inside of the base material 1. In addition, it is also preferable to press the blade body until the blade at the tip end of the blade body penetrates through the base material 1.

### [Second Embodiment]

An example of a method of manufacturing the module 10B shown in FIG. 3 and FIG. 4 will be described.

After forming a laminated body in the same manner as in the case of the manufacturing method according to the first embodiment, as the conduction material 5, a pin body such as a nail, a needle, a wedge, and a thin rod formed from a conductive material instead of the blade body is inserted into the laminated body. According to this, the module 10B is obtained. The number of the pin body that is inserted may be one, but it is preferable that a plurality of the pin bodies are provided from the viewpoint of reducing electrical resistance in series connection.

### [Third Embodiment]

An example of a method of manufacturing the module 10C shown in FIG. 5 and FIG. 6 will be described.

A laminated body is formed in the same manner as in the case of the manufacturing method according to the first embodiment, and the blade body that constitutes the conduction material 5 is inserted into the laminated body. At this time, the blade body is inserted until a blade at a tip end S of the blade body penetrates through the base material 1. According to this, the module 10C is obtained.

### [Fourth Embodiment]

An example of a method of manufacturing the module 10D shown in FIG. 7 and FIG. 8 will be described.

A laminated body is formed in the same manner as in the case of the manufacturing method according to the first embodiment, and the blade body that constitutes the conduction material 5 is inserted into the laminated body. At this time, as the blade body, a blade body in which a cross-sectional shape in the longitudinal direction (Z direction) is a V-shape, and a V-shaped valley is a cavity (hollow) is used. After connecting the first photoelectric conversion element C1 and the second photoelectric conversion element C2 in series by the blade that is inserted, a resin composition that constitutes the support material 6 is applied on the connection portion J that includes the blade body. The hollow portion of the blade body is filled with the resin composition, and the P-type semiconductor layer 33, which is exposed between both of the photoelectric conversion elements C1 and C2, is covered with the resin composition. Then, the resin composition is cured by a known method. At this time, the resin composition may be cured after not only the connection portion J but also the entirety of the upper surface of the module over the first photoelectric conversion element C1 to second photoelectric conversion element C2 is covered with the resin composition. In this manner, when the support material 6 supports the upper surface of the module, structural strength of the module is improved, and thus the module 10D in which the connection portion J is fixed by the support material 6 is obtained.

### [Fifth Embodiment]

An example of a method of manufacturing the module 10E shown in FIG. 9 and FIG. 10 will be described.

After forming a laminated body in the same manner as in the manufacturing method according to the first embodiment, the compression material 7 is pressed to the laminated body from an upper side of the second conductive layer 4a of the first photoelectric conversion element C1 to press the end 4aa of the second conductive layer 4a into the laminated body. The end 4aa is recessed until the end 4aa comes into contact with the end 2bb of the first conductive layer 2b of the second photoelectric conversion element C2, and thus the end 4aa extends along the lateral surface of the first photoelectric conversion element C1. When the extended end 4aa and the first conductive layer 2b are electrically connected to each other, the extension portion G is formed, and the module 10E, which includes the connection portion J that connects the first photoelectric conversion element C1 and the second photoelectric conversion element C2 in series, is obtained.

In the laminated body, the P-type semiconductor layer 33 is exposed between the second conductive layer 4a and the second conductive layer 4b which are spaced away from each other. It is possible to recess the end 4aa of the second conductive layer 4a by pressing the compression material 7 to the vicinity of the end 4aa of the second conductive layer 4a in an exposed portion or the end 4aa of the second conductive layer 4a. As the end 4a is recessed in combination with the compression material 7, the end 4a penetrates through the power generation layer 3 and reaches the end 2bb of the first conductive layer 2b.

### [Sixth Embodiment]

An example of a method for manufacturing the module 10F shown in FIG. 11 and FIG. 12 will be described.

After forming a laminated body in the same manner as in the manufacturing method according to the first embodiment, a plurality of compression materials 7 of which a length in the Z direction is shorter than that of the single compression material 7 that is used in the fifth embodiment are discontinuously disposed in a state of being spaced away from each other along the longitudinal direction (Z direction) of the connection portion J. In addition, the compression materials 7 are pressed in order for the laminated body to be recessed, thereby forming the connection portion J. According to this, the module 10F is obtained in the same manner as in the manufacturing method according to the fifth embodiment.

### [Seventh Embodiment]

An example of a method for manufacturing the module 10G shown in FIG. 13 and FIG. 14 will be described.

In this example, a covering material, which includes the support material 7b having a surface capable of covering the upper surface of the first photoelectric conversion element C1 disposed as a laminated body and the upper surface of the second photoelectric conversion element C2 disposed as a laminated body, and the compression material 7a that is integrated with the support material 7b and protrudes to a lower side of the support material 7b, is used. The shape of a protrusion of the compression material 7a that is integrated with the support material 7b is the same as in the compression material 7 according to the fifth embodiment or the sixth embodiment.

After forming a laminated body in the same manner as in the manufacturing method according to the fifth embodiment, the covering material is placed on an upper surface of the laminated body, and is pressed thereto. At this time, the compression material 7a that protrudes toward a lower side is pressed in the same manner as in the case of pressing the compression material 7 according to the fifth embodiment and the sixth embodiment in order for laminated body to be recessed by the end 4aa of the second conductive layer 4a, thereby forming the extension portion G. In addition, the support material 7b that constitutes the covering material supports the upper surface of the module 10G in a range from the first photoelectric conversion element C1 to the second photoelectric conversion element C2.

According to the method, the structural strength of the module 10G is improved, and the module 10G in which the compression material 7a is fixed by the support material 7b is obtained.

### [Comparative Example 1]

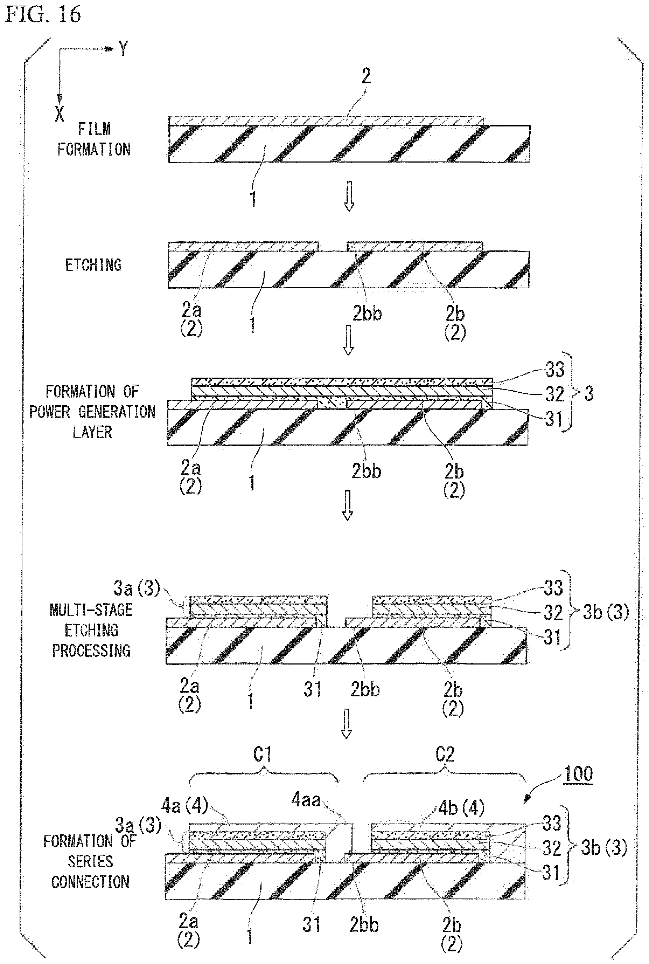

A description will be given of a method for manufacturing a module that does not include the conduction material 5 and the compression material 7 according to comparative examples with reference to FIG. 16.

First, a first conductive layer 2 is formed on a base material 1 by physical vapor deposition to form a first conductive layer 2a and a first conductive layer 2b which are spaced away from each other are formed in a pattern corresponding to compartment of a first photoelectric conversion element C1 and a second photoelectric conversion element C2.

Subsequently, an N-type semiconductor layer 31, a perovskite layer 32, and a P-type semiconductor layer 33 are sequentially laminated on the first conductive layer 2a and the first conductive layer 2b, thereby forming a power generation layer 3.

Subsequently, etching processing, which conforms to etching characteristics of respective layers constituting the power generation layer 3, is performed to divide the power generation layer 3 in a pattern corresponding to the compartment of the first photoelectric conversion element C1 and the second photoelectric conversion element C2. Typically, it is difficult to complete the etching processing at a time. For example, multi-step etching processing is performed in the order of the P-type semiconductor layer 33, the perovskite layer 32 including an underlying layer, and the N-type semiconductor layer 31.

Then, masking is performed and physical vapor deposition is performed to form a second conductive layer 4a and the second conductive layer 4b which are spaced away from each other. At this time, the film formation is also performed on a lateral surface of the first photoelectric conversion element C1 to connect an end 4aa of the second conductive layer 4a and the first conductive layer 2b to each other, thereby connecting the first photoelectric conversion element C1 and the second photoelectric conversion element C2 in series.

Through the above-described process, a solid-junction photoelectric conversion element module 100 according to the comparative example is manufactured.

In a manufacturing method according to Comparative Example 1, it is difficult to accurately and finely compartment a power generation layer 3a and a power generation layer 3b through the multi-step etching processing in many cases. Even though the compartment is realized, an advanced technology is required.

In addition, when forming the series connection by forming a film on the lateral surface of the first photoelectric conversion element C1, it is necessary for the film not to be widely formed up to a lateral surface of the second photoelectric conversion element C2 that faces a film formation surface (the lateral surface of C1). Accordingly, an advanced technology is required.

As described above, in the manufacturing method according to Comparative Example 1, various advanced technologies are required, and thus it is difficult to manufacture the solid-junction photoelectric conversion element module at a satisfactory yield.

### [Comparative Example 2]

To avoid the multi-step etching processing, the following another manufacturing method can be considered. Specifically, when forming the power generation layer 3 including the N-type semiconductor layer 31, the perovskite layer 32 including the underlying layer, and the P-type semiconductor layer 33, masking is performed to form the power generation layer 3a and the power generation layer 3b in a compartmented state.

However, typically, the power generation layer 3 is formed by applying a solution that contains a raw material, and drying the solution. Accordingly, even though masking is performed, a boundary of an application portion and a non-application portion of the solution is likely to be ambiguous, and thus it is difficult to compartment the power generation layer 3a and the power generation layer 3b with accuracy in many cases. Even though the compartment is realized, an advanced technology is required. Accordingly, it is difficult to employ the manufacturing method from the viewpoint of performing manufacturing at a satisfactory yield.

### [Effect of Manufacturing Method According to Invention]

In the manufacturing method according to the invention, complicated processing for compartmenting the power generation layer 3 is not necessary. The conduction material 5 or the compression material 7 penetrates through the power generation layer 3 by inserting the conduction material 5 or by pressing the compression material 7 into the laminated body, and thus it is possible to conveniently form the connection portion J. Accordingly, according to the manufacturing method of the invention, it is possible to conveniently manufacture the solid-junction photoelectric conversion element module according to the invention at a satisfactory yield.

In this specification, to discriminate a layer configuration of the first photoelectric conversion element and a layer configuration of the second photoelectric conversion element, the first conductive layer of the second photoelectric conversion element may be referred to as a third conductive layer, and the second conductive layer of the second photoelectric conversion element may be referred to as a fourth conductive layer. In the same manner, the power generation layer of the first photoelectric conversion element may be referred to as a first power generation layer, and the power generation layer of the second photoelectric conversion element may be referred as a second power generation layer. In addition, the perovskite layer of the first photoelectric conversion element may be referred to as a first perovskite layer, and the perovskite layer of the second photoelectric conversion element may be referred to as a second perovskite layer.

Respective configurations, combinations thereof, and the like in the above-described embodiments are illustrative only, and addition, omission, substitution, and other modifications of configurations can be made in a range not departing from the gist of the invention.

### Industrial Applicability

The solid-junction photoelectric conversion element module and the method for manufacturing the same according to the invention can be widely used in a field of solar power generation.

### Reference Signs List

1: Base material
2: First conductive layer
2a: First conductive layer
2b: First conductive layer (third conductive layer)
2bb: End
3: Power generation layer
3a: Power generation layer (first power generation layer)
3b: Power generation layer (second power generation layer)
4: Second conductive layer
4a: Second conductive layer
4aa: End
4b: Second conductive layer (fourth conductive layer)
5: Conduction material
6: Support material
7: Compression material
10: Solid-junction photoelectric conversion element module
31: N-type semiconductor layer
32: Perovskite layer
33: P-type semiconductor layer
100: Solid-junction photoelectric conversion element module of comparative example
C1: First photoelectric conversion element
C2: Second photoelectric conversion element
G: Extension portion
J: Connection portion
S: Tip end

## Claims

1. A solid-junction photoelectric conversion element module, comprising:
a first photoelectric conversion element;
a second photoelectric conversion element;
a connection portion; and
a base material,
wherein the first photoelectric conversion element and the second photoelectric conversion element are disposed adjacently to each other on a surface of the base material,
the first photoelectric conversion element sequentially includes a first conductive layer, a power generation layer including a perovskite layer, and a second conductive layer, and the first conductive layer of the first photoelectric conversion element is in contact with the base material,
the second photoelectric conversion element sequentially includes a first conductive layer, a power generation layer including a perovskite layer, and a second conductive layer, and the first conductive layer of the second photoelectric conversion element is in contact with the base material, and
the connection portion connects the second conductive layer of the first photoelectric conversion element and the first conductive layer of the second photoelectric conversion element, and is in contact with the power generation layer of the first photoelectric conversion element and the power generation layer of the second photoelectric conversion element.

2. The solid-junction photoelectric conversion element module according to claim 1,
wherein the connection portion is continuously disposed along a space between the first photoelectric conversion element and the second photoelectric conversion element.

3. The solid-junction photoelectric conversion element module according to claim 1,
wherein the connection portion is discontinuously disposed along a space between the first photoelectric conversion element and the second photoelectric conversion element.

4. The solid-junction photoelectric conversion element module according to any one of claims 1 to 3,
wherein the connection portion is formed from a conduction material.

5. The solid-junction photoelectric conversion element module according to any one of claims 1 to 3,
wherein the connection portion includes an extension portion in which an end of the second conductive layer of the first photoelectric conversion element extends and which is connected to the first conductive layer of the second photoelectric conversion element, and a compression material that is disposed along the extension portion.

6. The solid-junction photoelectric conversion element module according to claim 4,
wherein the conduction material protrudes from a rear surface of the base material.

7. The solid-junction photoelectric conversion element module according to any one of claims 1 to 6, further comprising:
an insulating material that covers the second conductive layer of the first photoelectric conversion element, the connection portion, and the second conductive layer of the second photoelectric conversion element.

8. A method for manufacturing the solid-junction photoelectric conversion element module according to claim 4, the method comprising:
a step of forming the first conductive layer of the first photoelectric conversion element, and the first conductive layer of the second photoelectric conversion element which is spaced away from the first conductive layer of the first photoelectric conversion element on the base material;
a step of forming a continuous power generation layer including a perovskite layer over the first conductive layer of the first photoelectric conversion element and the first conductive layer of the second photoelectric conversion element;
a step of forming the second conductive layer of the first photoelectric conversion element and the second conductive layer of the second photoelectric conversion element, which is spaced away from the second conductive layer of the first photoelectric conversion element, on the power generation layer; and
a step of forming the connection portion by inserting the conduction material between the second conductive layer of the first photoelectric conversion element and the second conductive layer of the second photoelectric conversion element from the second conductive layer side of the first photoelectric conversion element, and pressing the conduction material until the conduction material penetrates through the power generation layer and comes into contact with the first conductive layer of the second photoelectric conversion element.

9. A method for manufacturing the solid-junction photoelectric conversion element module according to claim 5, the method comprising:
a step of forming the first conductive layer of the first photoelectric conversion element, and the first conductive layer of the second photoelectric conversion element which is spaced away from the first conductive layer of the first photoelectric conversion element on the base material;
a step of forming a continuous power generation layer including a perovskite layer over the first conductive layer of the first photoelectric conversion element and the first conductive layer of the second photoelectric conversion element;
a step of forming the second conductive layer of the first photoelectric conversion element and the second conductive layer of the second photoelectric conversion element, which is spaced away from the second conductive layer of the first photoelectric conversion element, on the power generation layer; and
a step of forming the connection portion by pressing the compression material to an end of the second conductive layer of the first photoelectric conversion element between the second conductive layer of the first photoelectric conversion element and the second conductive layer of the second photoelectric conversion element, and pressing the compression material until the end, which is pressed and recessed by the compression material, penetrates through the power generation layer and further comes into contact with the first conductive layer of the second photoelectric conversion element.
